# EUROPEAN PATENT SPECIFICATION

(11) **EP 0 455 002 B1**
(45) Date of publication and mention of the grant of the patent: **29.12.1997**
(21) Application number: 91105323.9
(22) Date of filing: 04.04.1991
(51) Int. Cl.: H03K 19/0185, H03K 19/003

(54) **A data output stage of the buffer type, having reduced noise to ground, for logic circuits of the CMOS type**
Datenausgabestufe des Puffertyps für CMOS-Logikschaltungen mit vermindertem Störgeräusch gegenüber Masse
Etage de sortie de données du type tampon pour circuits logiques CMOS à bruit réduit par rapport à la masse

(30) Priority: 27.04.1990 IT 2015790
(43) Date of publication of application: 06.11.1991
(73) Proprietor: SGS-THOMSON MICROELECTRONICS s.r.l., 20041 Agrate Brianza (Milano) (IT)
(72) Inventor: Rolandi, Paolo, I-15059 Volpedo - Alessandria (IT); Maccalli, Marco, I-20066 Novate Milanese - Milano (IT); Dallabora, Marco, I-20077 Melegnano - Milano (IT)
(74) Representative: Perani, Aurelio

(56) References cited:
- EP-A- 0 121 217
- EP-A- 0 384 673
- PATENT ABSTRACTS OF JAPAN vol. 12, no. 124 (E-601)(2971), 16 April 1988; & JP - A - 62248306 (MITSUBISHI ELECTRIC CORP.) 29.10.1987
- PATENT ABSTRACTS OF JAPAN vol. 11, no. 162 (P-579)(2609), 26 May 1987; & JP - A - 294682 (HITACHI LTD) 25.12.1986
- PATENT ABSTRACTS OF JAPAN vol. 12, no. 361 (P-763)(3208), 28 September 1988; & JP - A - 63112893 (MITSUBISHI ELECTRIC CORP.) 17.05.1988
- PATENT ABSTRACTS OF JAPAN vol. 11, no. 400 (E-569)(2847), 26 December 1987; && JP - A - 62159910 (MITSUBISHI ELECTRIC CORP) 15.07.1987
- PATENT ABSTRACTS OF JAPAN vol. 13, no. 503 (E-844)(3851), 13 November 1989; && JP - A - 1220819 (TOSHIBA CORP.) 14.08.1989
- PATENT ABSTRACTS OF JAPAN vol. 11, no. 400 (E-569)(2847), 26 December 1987; && JP - A - 62159911 (MITSUBISHI ELECTRIC CORP) 15.07.1987

## Description

This invention relates to a data output stage of the buffer type, as defined in the preamble of the claim.

As is known, circuit devices of the above-outlined kind are useful to prevent undesired electric interactions between a driver circuit and a driven circuit.

A first prior approach to the problem of providing such a buffer is disclosed, for example, in European Patent No. EP 0 284 357 to Toshiba.

That patent describes the construction of a driver circuit incorporating a large-size CMOS inverter. The use of that inverter as a buffer involves problems from the high sensitivity of the circuit to switching noise.

A second prior approach is disclosed in European Patent No. EP 0 251 910 to Fujitzu, whereby the switching noise of a data output buffer is reduced by driving the gates of the driver through a suitable RC circuit.

A major drawback of the last-mentioned approach is the reduced speed of the entire circuit.

Also known are other types of driver circuits which provide for a pre-discharge step of the output, which is brought to a logic high consistent with logics of the TTL type. This pre-discharge step is clocked by an internal clock of the circuit, which is caused to operate prior to enabling the buffer stage.

The latter circuit arrangement does afford a reduction in noise on the output being switched from a logic high to a logic low, but has proved ineffective as it is switched the other way.

EP-A-0 384 673, which has priority dates earlier than the priority date of this application and was published after that date, discloses an output circuit with a precharging circuit for sensing and precharging the level of an output terminal to an intermediate level. This known precharging circuit comprises two output transistors with structurally independent feedback networks which include NOR and NAND gates to provide respective threshold voltages above and below the intermediate level.

Patents Abstracts of Japan, vol 12, no. 124 (E-601) (2971) & JP-A-62 248 306 discloses an output buffer having two feedback networks to precharge its output to a level intermediate to a high and a low logic level, according to the preamble portion of the claim.

Patents Abstracts of Japan, vol. 11, no. 162 (P-579) (2609) & JP-A-61 294 682 discloses an output buffer with two feedback networks having a common inverter.

The underlying technical problem of this invention is to provide a data output stage of the buffer type, having such structural and functional characteristics as to reduce the noise to ground during the switching step and overcome the above-mentioned drawbacks with which the prior art is beset.

This technical problem is solved by an output stage as defined and characterized in the claim.

The features and advantages of an output circuit stage according to the invention will become apparent from the following detailed description of an exemplary embodiment thereof, given by way of illustration and not of limitation with reference to the accompanying drawings.

In the drawings:

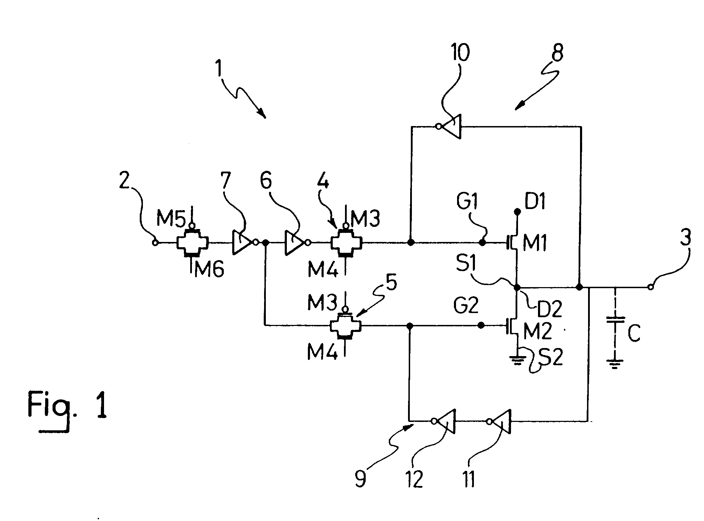

Figure 1 is a circuit diagram showing schematically the output stage of this invention; and
Figures 2 and 3 are respective comparative graphs of the current values which appear in the stage of Figure 1 and in circuits according to the prior art.

With reference to the drawing figures, generally shown at 1 is a data output stage of the buffer type embodying this invention and being intended for high switching rate, CMOS-type logic circuits.

The stage 1 comprises a pair of MOS transistors M1 and M2 which are associated to drive an output node 3. More particularly, the source electrode S1 of transistor M1 is connected to the drain electrode D2 of transistor M2, and these electrodes are both connected to the output node 3.

The source S2 of transistor M2 is connected to ground, whilst the drain D1 of transistor M1 is connected to a power supply pole, not shown because conventional.

Each transistor, M1 and M2, is provided with a conventional gate electrode G1 and G2 being connected electrically each to the output of respective circuit portions 4 and 5.

Such portions 4 and 5 are each comprised basically of a pair of MOS transistors, M3 and M4, having their respective source and drain electrodes connected in parallel with each other.

The drains D3 and D4 of each pair of transistors M3 and M4 are connected directly to each corresponding gate electrode G1 and G2.

The source electrodes of the first circuit portion 4 are connected to the output of an inverter 6, whilst the corresponding souce electrodes of the other portion 5 are connected to the input of said inverter 6.

Provided upstream of said inverter 6 is an additional inverter 7 which has its input connected to the drain electrodes of a pair of MOS transistors M5 and M6, connected in parallel, of which the source electrodes constitute a signal input 2 for the stage 1.

Advantageously, according to this invention, the stage comprises first 8 and second 9 feedback networks which are structurally independent and respectively connected between the output node 3 and a corresponding gate electrode, G1 and G2, of each transistor M1 and M2.

The first network 8 comprises an inverter 10 having its input connected to the node 3 and its output connected to the gate G1.

The second loop 9 comprises a pair of inverters 11 and 12 connected serially to each other, with the input of the inverter 11 being connected to the node 3 and the output of the inverter 12 to the gate G2.

The circuit structure of this invention allows the output node 3 to be pre-charged irrespective of the type of stage 1 switching.

In essence, the circuit structure of this invention allows the capacitive load on the node 3 to be brought to an intermediate voltage to a logic low and a logic high consistent with logics of the TTL type.

The transistor M1 operates as a pull-up for the output stage 1, whereas the other transistor, M2, operates as a pull-down.

In the preferred embodiment being discussed, the threshold voltage of each feedback loop formed by networks 8 and 9 is selected to bring the output node 3 to an intermediate voltage value to the potential difference between the switching levels which, with logics of the TTL type is of 1.4 Volts. With the inventive circuit, this will occur independently of the voltage value appearing at the load connected to the node 3.

The threshold voltage of the loop with network 8 is set at 1.3 Volts, and that of the loop with the lower network 9 is set at a value of 1.6 Volts. In this way, the loop with networks 8 and 9 are made operatively independent so as to avoid undesired oscillations.

As an example, assuming a starting state whereby a logic high is present on the output node 3, the pull-down transistor M2 will be enabled because of the threshold of the loop with network 9 being set at 1.6 Volts. Under this condition, the node 3 will commence to discharge down to the threshold voltage value Vs.

Due to the propagation delay of the inverters, 11 and 12, the transistor M2 is turned off on the node 3 reaching a voltage value of 1.4 Volts.

Assuming, on the other hand, that in a starting condition, the output 3 is at a logic low, the pull-up transistor M1 will be enabled, and the node 3 charged up to the threshold voltage value present at the upper loop 8.

The turn-off delay of the transistor M1 is less than that of the transistor M2, and accordingly, even under this operating condition, the voltage value present at the node 3 will be of 1.4 Volts.

The feedback loops with networks 8 and 9 will be simultaneously operational in neither of these examples of operation.

The output stage of this invention allows the current peak which appears during-the switching step to be lowered, thereby providing a reduction in the noise on the power supplies.

Actual tests carried out by the Applicant have permitted the circuit performance to be analysed both in terms of gain and phase edge in comparison with circuits according to the prior art.

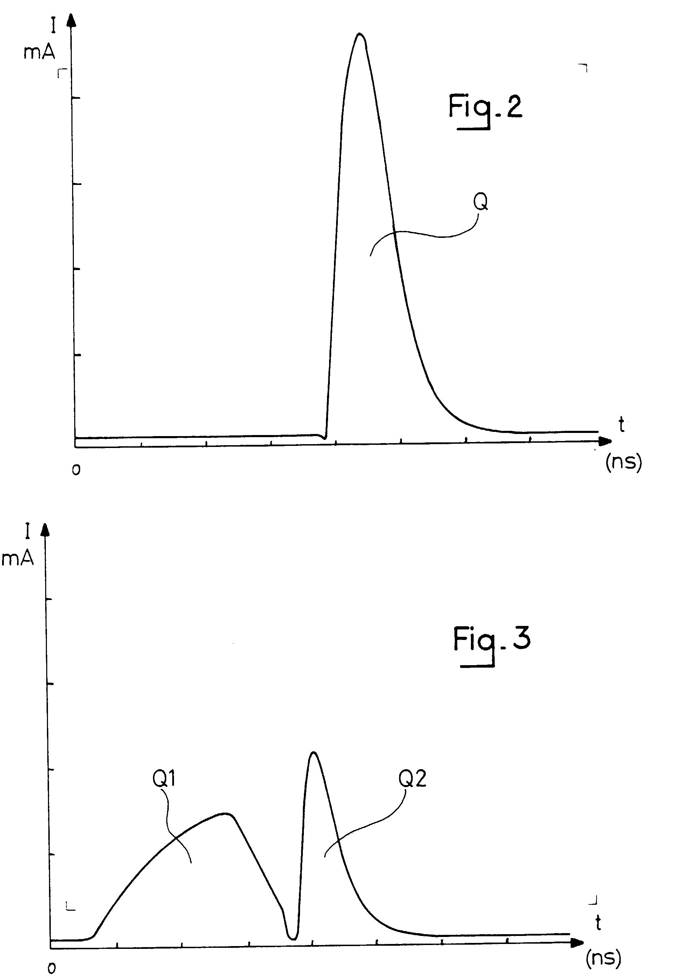

For demonstrative purposes, plotted in Figures 2 and 3 are the behaviors of the switching current value versus time, for conventional circuits and the circuit of this invention.

It may be appreciated from these graphs that, in the inventive circuit, the charge Q = Q1 + Q2 stored on the output capacitor C is scattered over a longer time period (Figure 3) than in circuits of conventional design.

This effectively lowers the current peak during the switching phase.

## Claims

1. A data output stage (1) of the buffer type, having low noise to ground and for use in CMOS logic circuits, which comprises at least one pair of MOS output transistors (M1 and M2) associated in a push-pull arrangement to drive an output node (3) of said stage (1), and first (8) and second (9) structurally independent feedback networks which are respectively connected between said node (3) and a gate electrode (G1, G2) of a corresponding one of said MOS output transistors (M1 and M2) to form a first and second feedback loops and pre-charge said output node (3) to approximately a predetermined voltage level, said first feedback network (8) being arranged to raise the voltage at said output node (3) toward said predetermined voltage level when the voltage at said output node (3) is below a first threshold voltage lower than said predetermined voltage level, and said second feedback network (9) being arranged to lower the voltage at said output node (3) toward said predetermined voltage level when said voltage at said output node (3) is above a second threshold voltage higher than said predetermined voltage level, said data output stage comprising a first circuit portion (4) for coupling a signal input to the gate (G1) of one (M1) of said MOS output transistors and a second circuit portion (5) for coupling said signal input to the gate (G2) of the other (M2) of said MOS output transistors, each of said first and second circuit portions (4, 5) consisting of a pair of MOS transistors (M3, M4) the respective source and drain electrodes of which are connected to each other,
**characterized in that** said first network (8) comprises a first inverter (10) having its input connected to said output node (3) and its output directly connected to the gate electrode (G1) of said one (M1) of said MOS output transistors, and said second network (9) comprises a second inverter (11) and a third inverter (12) connected in series with each other, the input of the second inverter (11) being connected to the said output node (3) and the output of the third inverter (12) being directly connected to the gate (G2) of said other (M2) of said MOS output transistors; and in that said first circuit portion (4) is coupled to said signal input through a fourth inverter (6) whereas said second circuit portion (5) is directly connected to said signal input.

## Patentansprüche

1. Eine Datenausgabestufe (1) des Puffertyps, mit einem niedrigen Rauschen gegenüber der Masse und zur Verwendung in CMOS-Logikschaltungen, wobei dieselbe mindestens ein Paar von MOS-Ausgangstransistoren (M1 und M2), die in einer Gegentakt-Anordnung verknüpft sind, um einen Ausgangsknoten (3) der Stufe (1) zu treiben, und ein erstes (8) und ein zweites (9) Rückkopplungsnetz aufweist, die strukturell unabhängig sind, und jeweils zwischen den Knoten (3) und eine Gateelektrode (G1, G2) eines entsprechenden der MOS-Ausgangs-Transistoren (M1 und M2) geschaltet sind, um eine erste und eine zweite Rückkopplungsschleife zu bilden, und um den Ausgangsknoten (3) ungefähr auf einen vorbestimmten Spannungspegel vorzuladen, wobei das erste Rückkopplungsnetz (8) angeordnet ist, um die Spannung an dem Ausgangsknoten (3) zu dem vorbestimmten Spannungspegel hin anzuheben, wenn die Spannung an dem Ausgangsknoten (3) unter einer ersten Schwellenspannung ist, die niedriger als der vorbestimmte Spannungspegel ist, und wobei das zweite Rückkopplungsnetz (9) angeordnet ist, um die Spannung an dem Ausgangsknoten (3) zu dem vorbestimmten Spannungspegel hin zu erniedrigen, wenn die Spannung an dem Ausgangsknoten (3) oberhalb einer zweiten Schwellenspannung ist, die höher ist als der vorbestimmte Spannungspegel, wobei die Datenausgabestufe einen ersten Schaltungsabschnitt (4) zum Koppeln eines Signaleingangs an das Gate (G1) eines (M1) der MOS-Ausgangstransistoren und einen zweiten Schaltungsabschnitt (5), zum Koppeln des Signaleingangs mit dem Gate (G2) des anderen (M2) der MOS-Ausgangstransistoren aufweist, wobei sowohl der erste als auch der zweite Schaltungsabschnitt (4, 5) aus einem Paar von MOS-Transistoren (M3, M4) bestehen, wobei die Source- bzw. die Drainelektroden derselben miteinander verbunden sind,
dadurch gekennzeichnet, daß das erste Netz (8) einen ersten Invertierer (10) aufweist, dessen Eingang mit dem Ausgangsknoten (3) verbunden ist, und dessen Ausgang direkt mit der Gateelektrode (G1) des einen (M1) der MOS-Ausgangstransistoren verbunden ist, und wobei das zweite Netz (9) einen zweiten Invertierer (11) und einen dritten Invertierer (12) aufweist, die seriell miteinander verbunden sind, wobei der Eingang des zweiten Invertierers (11) mit dem Ausgangsknoten (3) verbunden ist, und der Ausgang des dritten Invertierers (12) direkt mit dem Gate (G2) des anderen (M2) der MOS-Ausgangstransistoren verbunden ist; und daß der erste Schaltungsabschnitt (4) mit dem Signaleingang durch einen vierten Invertierer (6) gekoppelt ist, während der zweite Schaltungsabschnitt (5) direkt mit dem Signaleingang verbunden ist.

## Revendications

1. Etage de sortie de données (1) du type tampon, ayant un faible bruit par rapport à la masse et prévu pour l'utilisation dans des circuits logiques CMOS, qui comprend au moins une paire de transistors de sortie MOS (M1 et M2) associés en une configuration symétrique pour attaquer un noeud de sortie (3) de cet étage (1), et des premier (8) et second (9) réseaux de réaction, indépendants au point de vue de la structure, qui sont respectivement connectés entre le noeud (3) et une électrode de grille (G1, G2) de l'un correspondant des transistors de sortie MOS (M1 et M2), pour former des première et seconde boucles de réaction et pour pré-charger le noeud de sortie (3) approximativement à un niveau de tension prédéterminé, le premier réseau de réaction (8) étant conçu pour élever la tension au noeud de sortie (3) vers le niveau de tension prédéterminé, lorsque la tension au noeud de sortie (3) est au-dessous d'une première tension de seuil inférieure au niveau de tension prédéterminé, et le second réseau de réaction (9) étant conçu pour abaisser la tension au noeud de sortie (3) vers le niveau de tension prédéterminé lorsque la tension au noeud de sortie (3) est au-dessus d'une seconde tension de seuil supérieure au niveau de tension prédéterminé, cet étage de sortie de données comprenant une première partie de circuit (4) pour coupler une entrée de signal à la grille (G1) d'un premier (M1) des transistors de sortie MOS, et une seconde partie de circuit (5) pour coupler l'entrée de signal à la grille (G2) de l'autre (M2) des transistors de sortie MOS, chacune des première et seconde parties de circuit (4, 5) consistant en une paire de transistors MOS (M3, M4) dont les électrodes de source et de drain respectives sont connectées l'une à l'autre,
caractérisé en ce que le premier réseau (8) comprend un premier inverseur (10) dont l'entrée est connectée au noeud de sortie (3) et dont la sortie est directement connectée à l'électrode de grille (G1) du premier (M1) des transistors de sortie MOS, et le second réseau (9) comprend un second inverseur (11) et un troisième inverseur (12) connectés mutuellement en série, l'entrée du second inverseur (11) étant connectée au noeud de sortie (3), et la sortie du troisième inverseur (12) étant directement connectée à la grille (G2) de l'autre (M2) des transistors de sortie MOS; et en ce que la première partie de circuit (4) est couplée à l'entrée de signal par l'intermédiaire d'un quatrième inverseur (6), tandis que la seconde partie de circuit (5) est directement connectée à l'entrée de signal.
